# EUROPEAN PATENT APPLICATION

(11) **EP 4 369 417 A1**
(43) Date of publication of application: **15.05.2024**
(21) Application number: 22863247.7
(22) Date of filing: 24.08.2022
(51) Int. Cl.: H01L 29/786, H01L 21/336

(54) **METAL OXIDE THIN FILM TRANSISTOR AND MANUFACTURING METHOD THEREFOR, AND DISPLAY PANEL**

(30) Priority: 31.08.2021 CN 202111016209
(71) Applicant: BOE Technology Group Co., Ltd., Chaoyang District, Beijing 100015 (CN); Fuzhou Boe Optoelectronics Technology Co., Ltd., Fuzhou, Fujian 350300 (CN)
(72) Inventor: LIN, Bin, Beijing 100176 (CN); WANG, Yang, Beijing 100176 (CN); ZOU, Zhenyou, Beijing 100176 (CN); LE, Fadian, Beijing 100176 (CN); XI, Wenxing, Beijing 100176 (CN); YU, Xue, Beijing 100176 (CN)
(74) Representative: Haseltine Lake Kempner LLP
(86) International application number: PCT/CN2022/114382
(87) International publication number: WO 2023/030108

(57) **Abstract**

Disclosed are a metal oxide thin film transistor and a manufacturing method therefor, and a display panel, relating to the field of display technology. Since the oxygen content in a first insulation layer of the metal oxide thin film transistor is high, the oxygen in the first insulation layer may diffuse into a metal oxide semiconductor layer, so that oxygen replenishment for the metal oxide semiconductor layer is achieved, and the stability of the metal oxide thin film transistor is thereby improved. In addition, the first insulation layer matches the metal oxide semiconductor layer at an interface therebetween, which may reduce surface defects of the metal oxide semiconductor layer. In addition, the percentage by number of oxygen atoms contained in the metal oxide semiconductor layer is greater than 45%, such that an excessive amount of oxygen vacancies in the metal oxide semiconductor layer is prevented, and the characteristic negative bias of the metal oxide thin film transistor is not easily caused when a device works. In this way, sand point defects of products caused by the characteristic negative bias of the metal oxide thin film transistor may be effectively reduced.

## Description

The present disclosure is based upon and claims priority to Chinese Patent Application No. 202111016209.3, filed on August 31, 2021, and entitled "METAL OXIDE THIN FILM TRANSISTOR AND METHOD FOR MANUFACTURING SAME, AND DISPLAY DEVICE," the content of which is herein incorporated by reference in its entirety.

### TECHNICAL FIELD

The present disclosure relates to the field of display technologies, and in particular, relates to a metal oxide thin film transistor and a method for manufacturing the same, and a display device.

### BACKGROUND

Indium gallium zinc oxides (IGZO) are widely used in preparing channel layers of thin film transistors due to their advantages of high mobility, good homogeneity, and good transparency.

### SUMMARY

Embodiments of the present disclosure provide a metal oxide thin film transistor and a method for manufacturing the same, and a display device. The technical solutions are as follows.

In one aspect, a metal oxide thin film transistor is provided.

The metal oxide thin film transistor includes: a gate, a gate insulator layer, a metal oxide semiconductor layer, a source, a drain, and a first insulator layer that are successively stacked on a base substrate; wherein the first insulator layer is in contact with the metal oxide semiconductor layer; the first insulator layer is an inorganic insulator layer containing silicon and oxygen, and an atomic percentage of oxygen contained in the first insulator layer is greater than 50%; and an atomic percentage of oxygen contained in the metal oxide semiconductor layer is greater than 45%.

Optionally, a thickness of the first insulator layer is less than 2000 Å.

Optionally, a peak value of bond energy of a silicon-oxygen bond in the first insulator layer is greater than 1060 cm⁻¹ and does not exceed 1080 cm⁻¹.

Optionally, the first insulator layer is a silicon oxide-based film layer formed by controlling an oxygen content during a deposition process, and differences between atomic percentages of oxygen at a plurality of test positions along a thickness direction of the first insulator layer do not exceed 5%.

Optionally, the first insulator layer includes: a first surface and a second surface that are opposite to each other; wherein the first surface is a surface proximal to the metal oxide semiconductor layer, and the second surface is a surface distal from the metal oxide semiconductor layer; and in a plurality of test positions tested from the second surface to the first surface, the closer the test position is to the second surface, the greater is a difference between atomic percentages of oxygen contained at every adjacent two test positions, and the closer the test position is to the first surface, the smaller is the difference between atomic percentages of oxygen contained at every adjacent two test positions.

Optionally, the metal oxide thin film transistor further includes: a second insulator film, disposed on a side, distal from the metal oxide semiconductor layer, of the first insulator layer, wherein the second insulator film contains silicon, and further contains at least one of oxygen and nitrogen.

Optionally, the first insulator layer has an equal density at a plurality of test positions along a thickness direction; wherein the density of the first insulator layer is less than a density of the second insulator film; and during etching of the first insulator layer using a hydrogen fluoride solution, an etch rate is greater than 25 Å/s and does not exceed 40 Å/s.

Optionally, during etching of the first insulator layer using the hydrogen fluoride solution, the etch rate ranges from 28 Å/s to 35 Å/s.

Optionally, the second insulator film includes a silicon nitride film layer.

Optionally, the second insulator film includes a silicon oxide film layer and a silicon nitride film layer that are successively stacked on the first insulator layer; wherein an atomic percentage of oxygen in the silicon oxide film layer of the second insulator film does not exceed an atomic percentage of oxygen in a silicon oxide film layer of the first insulator layer, and a difference between the atomic percentage of oxygen in the silicon oxide film layer of the second insulator film and the atomic percentage of oxygen in the silicon oxide film layer of the first insulator layer is greater than 5% to 15%.

Optionally, the second insulator film includes a silicon oxide film layer, a silicon oxynitride film layer, and a silicon nitride film layer that are successively stacked on the first insulator layer; wherein an atomic percentage of oxygen in the silicon oxide film layer of the second insulator film does not exceed an atomic percentage of oxygen in a silicon oxide film layer of the first insulator layer, a difference between the atomic percentage of oxygen in the silicon oxide film layer of the second insulator film and the atomic percentage of oxygen in the silicon oxide film layer of the first insulator layer is greater than 5% to 15%.

Optionally, an atomic ratio of silicon to oxygen in the silicon oxide film layer is 33:67, an atomic ratio of silicon to oxygen to nitrogen in the silicon oxynitride film layer is 36:52:12, and an atomic ratio silicon to nitrogen in the silicon nitride film layer is 51:49.

Optionally, a ratio of a thickness of the first insulator layer to a thickness of the second insulator film ranges from 0.2 to 0.5.

Optionally, an atomic percentage of hydrogen contained in a silicon oxide film layer of the first insulator layer is less than 3%, and a percentage of silicon-hydrogen bonds in the silicon oxide film layer of the first insulator layer is less than 7%.

Optionally, a thickness of the source and a thickness of the drain are greater than 3000 Å and less than 6000 Å, the thickness of the first insulator layer is greater than 500 Å and does not exceed 1100 Å; and a slope angle of the source and a slope angle of the drain are both less than 60 degrees.

Optionally, the metal oxide semiconductor layer includes a first surface and a second surface that are opposite to each other, the first surface being closer to the base substrate; and a portion, proximal to the first surface, of the metal oxide semiconductor layer contains amorphous or nano-crystalline metal oxide, and a portion, proximal to the second surface, of the metal oxide semiconductor layer contains C-axis crystallized metal oxide; wherein the amorphous or nano-crystalline metal oxide contains at least one of indium, gallium, zinc, tin, and praseodymium; and the C-axis crystallized metal oxide contains at least one of indium, gallium, zinc, tin, and praseodymium.

Optionally, the amorphous or nano-crystalline metal oxide contains indium gallium zinc oxide, an atomic ratio of indium to gallium to zinc in the indium gallium zinc oxide being 4:2:3, 1:1:1, or 1:3:6; and the C-axis crystallized metal oxide contains indium gallium zinc oxide, an atomic ratio of indium to gallium to zinc in the indium gallium zinc oxide being 4:2:3, 1:1:1, or 1:3:6.

Optionally, a carrier mobility of a portion, proximal to the first surface, of the metal oxide semiconductor layer ranges from 10 cm²/V•s to 20 cm²/V•s.

In another aspect, a method for manufacturing a metal oxide thin film transistor is provided.

The method includes: forming a gate, a gate insulator layer, a metal oxide semiconductor layer, a source, a drain, and a first insulator layer on a base substrate; wherein the first insulator layer is in contact with the metal oxide semiconductor; the first insulator layer is an inorganic insulator layer containing silicon and oxygen, an atomic percentage of oxygen contained in the first insulator layer being greater than 50%; and an atomic percentage of oxygen contained in the metal oxide semiconductor layer is greater than 45%.

Optionally, forming the first insulator layer includes: introducing nitrous oxide and silicon tetrahydroxide into a reaction chamber, and forming the first insulator layer on the base substrate using a chemical vapor deposition device.

Optionally, the method further includes: forming an oxygen supplementation layer on a side, distal from the base substrate, of the first insulator layer, wherein the oxygen supplementation layer is made of oxide, an orthographic projection of the oxygen supplementation layer on the base substrate is at least partially overlapped with an orthographic projection of the metal oxide semiconductor layer on the base substrate, and oxygen atoms in the supplementation oxygen layer are capable of diffusing from the first insulator layer into the metal oxide semiconductor layer; and removing the oxygen supplementation layer.

Optionally, a deposition rate of the first insulator layer is greater than 10 Å/s.

Optionally, a deposition rate of the first insulator layer ranges from 14 Å/s to 16 Å/s.

In still another aspect, a display panel is provided. The display panel includes a base substrate, and a plurality of metal oxide thin film transistors as described above disposed on the base substrate.

### BRIEF DESCRIPTION OF DRAWINGS

For clearer descriptions of the technical solutions in the embodiments of the present disclosure, the following briefly introduces the accompanying drawings to be required in the descriptions of the embodiments. Apparently, the accompanying drawings in the following description show merely some embodiments of the present disclosure, and persons of ordinary skills in the art may still derive other drawings from these accompanying drawings without creative efforts.
FIG. 1 is a schematic structural diagram of a display panel according to some embodiments of the present disclosure;
FIG. 2 is a schematic structural diagram of a metal oxide semiconductor layer, a drain, and a first insulator layer according to some embodiments of the present disclosure;
FIG. 3 is a schematic diagram of a curve of a percentage of each element in a first insulator layer, a metal oxide semiconductor layer, and a gate insulator layer according to some embodiments of the present disclosure;
FIG. 4 is a schematic diagram of a relation between a ratio of dinitrogen oxide to silicon tetrafluoride and a peak value of a silicon-oxygen bond according to some embodiments of the present disclosure;
FIG. 5 is a schematic diagram of a test of forming a first insulator layer on a large-sized base substrate according to some embodiments of the present disclosure;
FIG. 6 is a schematic diagram of a curve of bond energy of a silicon-oxygen bond according to some embodiments of the present disclosure;
FIG. 7 is a partial schematic diagram of FIG. 6 in a region A;
FIG. 8 is a schematic structural diagram of another display panel according to some embodiments of the present disclosure;
FIG. 9 is a schematic structural diagram of another metal oxide semiconductor layer, another drain, and another first insulator layer according to some embodiments of the present disclosure;
FIG. 10 is a schematic structural diagram of still another metal oxide semiconductor layer, still another drain, and still another first insulator layer according to some embodiments of the present disclosure;
FIG. 11 is a schematic structural diagram of a gate insulator layer, a metal oxide semiconductor layer, and a first insulator layer according to some embodiments of the present disclosure;
FIG. 12 is a schematic structural diagram of a gate insulator layer, a drain, a first insulator layer, and a second insulator film according to some embodiments of the present disclosure;
FIG. 13 is a schematic structural diagram of a gate, a gate insulator layer, a first insulator layer, and a second insulator film according to some embodiments of the present disclosure;
FIG. 14 is a flowchart of a method for manufacturing a metal oxide thin film transistor according to some embodiments of the present disclosure; and
FIG. 15 is a schematic diagram of a relation between a temperature of a base substrate and a wet etch rate according to some embodiments of the present disclosure.

### DETAILED DESCRIPTION

The present disclosure is described in further detail with reference to the accompanying drawings, to clearly present the objects, technical solutions, and advantages of the present disclosure.

In the related art, a thin film transistor includes a gate, a gate insulator layer, a semiconductor layer, a source, a drain, and a passivation layer that are successively stacked along a direction away from the base substrate.

However, a content percentage of oxygen in the semiconductor layer in the related art is small, and the stability of the thin film transistor is poor.

In an oxide thin film transistor (TFT), it is important to control a balance of hydrogen (H) and oxygen (O) to control characteristics of the oxide TFT (e.g., to lower a drift of a threshold voltage (Vth) of the oxide TFT or to lower a leakage current). Factors affecting the characteristics of the oxide TFT, in addition to the need to control a target material or process condition of manufacturing a metal oxide semiconductor layer, further include the need to control target materials or process conditions of film layers that are in contact with the metal oxide semiconductor layer, such as controlling the gate insulator layer and the passivation layer. It is important to control the film qualities of these film layers.

In addition to satisfying the requirements of the characteristics of the oxide TFT, the productivity of mass production and the effect of mass production on the characteristics shall be considered to improve the yield. For example, it is necessary to ensure that the insulator layers (the gate insulator layer and the passivation layer) that are in contact with the metal oxide semiconductor layer of the oxide TFT do not crack during annealing. Moreover, there are also some requirements for the deposition rate and film quality of the insulator layer.

Some and all of the above technical problems are optimized by the limited embodiments of the present disclosure described hereinafter.

A metal oxide thin film transistor according to the embodiments of the present disclosure is employed in a display region or a region of a gate driver on array (GOA) circuit.

The metal oxide thin film transistor according to the embodiments of the present disclosure is employed in products such as a small-sized mobile device (Mobile), a notebook computer (NB), a tablet computer (iPAD), a small and middle-sized monitor (MNT), a middle and large-sized television (TV), and a middle and large-sized MNT.

The metal oxide thin film transistor according to the embodiments of the present disclosure is employed in the field of display or the field of chips. The field of display includes the fields of a liquid crystal display (LCD) display panel, an organic light-emitting diode (OLED) display panel, a quantum dot light-emitting diode (QLED) display panel, a micro light-emitting diode (micro LED) display panel, or sensing. The oxide thin film transistor according to the embodiments of the present disclosure is employed as a TFT in a pixel switch, a TFT in a GOA circuit, or a TFT in a pixel drive circuit.

The metal oxide thin film transistor according to the embodiments of the present disclosure is more effective when applicable to a product with a bottom gate back channel etch (BCE) structure, but is not limited to products with this structure. For example, the metal oxide thin film transistor is also applicable to a product with a top gate structure. The embodiments of the present disclosure are illustrated using the bottom gate BCE structure as an example.

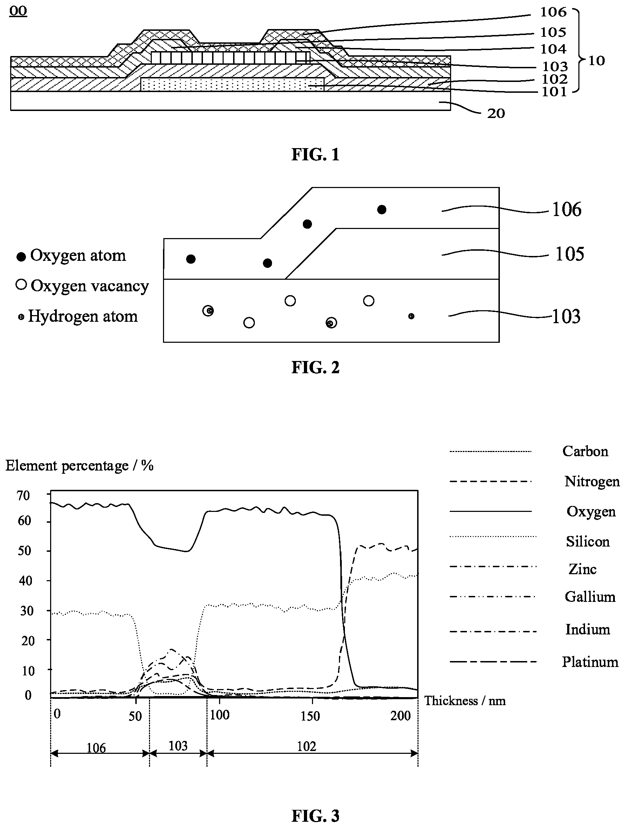

FIG. 1 is a schematic structural diagram of a display panel according to some embodiments of the present disclosure. Referring to FIG. 1, a metal oxide thin film transistor 10 in the display panel 01 includes a gate 101, a gate insulator (GI) layer 102, a metal oxide semiconductor layer 103, a source 104, a drain 105, and a first insulator layer 106 employed as a passivation layer that are successively disposed on a base substrate 20.

Referring to FIG. 1, the source 104 and the drain 105 are disposed in the same layer and are prepared using the same patterning process. Both the source 104 and the drain 105 are electrically connected to the metal oxide semiconductor layer 103.

Referring to FIG. 1, the gate insulator layer 102, the metal oxide semiconductor layer 103, the source 104, and the first insulator layer 106 are successively stacked along a direction away from the gate 101. A side, proximal to the gate 101, of the first insulator layer 106 is formed on the source 104 and the drain 105 and is in contact with the metal oxide semiconductor layer 103 that is between the source 104 and the drain 105. Exemplarily, a region, below the source 104 and the drain 105, in the metal oxide semiconductor layer 101 functions as a first region, and a region, between the source 104 and the drain 105, in the metal oxide semiconductor layer 101 functions as a second region. The side, proximal to the gate 101, of the first insulator layer 106 is in contact with the second region of the metal oxide semiconductor layer 103.

The first insulator layer 106 is a silicon oxide layer, and a film layer thereof is an inorganic insulator layer at least containing silicon (Si) and oxygen during a test of elemental composition. The first insulator layer 106 further contains a small number of nitrogen (N) atoms in an actual test, but the number of nitrogen atoms accounts for a very small percentage, such that the first insulator layer 106 is referred to as a silicon oxide (SiO) film layer.

Units of the terms of an atomic percentage, a percentage of atoms described herein are all Åt%, and the test device is a transmission electron microscope. For example, the atomic percentage is acquired by testing using a secondary ion mass spectroscopy (SIMS) analyzer.

In some embodiments, the first insulator layer 106 is a first passivation layer (PVX), which is an oxygen-rich film layer. Compared with a second insulator layer (a second passivation layer PVX2) or an insulator layer on the first insulator layer, the first insulator layer 106 proximal to the metal oxide semiconductor layer 103 is oxygen-rich.

An atomic percentage of oxygen contained in the first insulator layer 106 exceeds 50%, with an exemplary range from 50% to 75%. Exemplarily, a content percentage of oxygen in the first insulator layer 106 is 55%, 60%, 65%, or 70%.

In some embodiments, an atomic percentage of oxygen contained in the metal oxide semiconductor layer 103 is greater than 45%. In this case, oxygen vacancies within the metal oxide semiconductor layer 103 are not too much, which are not prone to a negative bias of the characteristics of the metal oxide thin film transistor during the operation of the TFT device, such that sand point defects of the product caused by the negative bias of the characteristics of the metal oxide thin film transistor are effectively solved.

Referring to FIG. 2, due to a large mobility of the metal oxide semiconductor layer 103, the metal oxide semiconductor layer 103 of the metal oxide thin film transistor has a large number of oxygen vacancies, and thus it is difficult to control the characteristics of the metal oxide thin film transistor. Therefore, designing the content percentage of oxygen in the first insulator layer 106 to be larger has at least the following advantages.

The first insulator layer 106 in contact with the metal oxide semiconductor layer 103 is oxygen-rich, and thus the number of hydrogen atoms contained in the first insulator layer 106 is small, which has the following advantages.
(1) It is advantageous to reduce a possibility that the hydrogen atoms enter the metal oxide semiconductor layer 103, such that the metal oxide semiconductor layer 103, which functions as an active layer, is avoided from being conductive.
(2) It is advantageous to reduce a possibility that oxide layers on surfaces of the source 104 and the drain 105 combine with hydrogen atoms to form water, such that the source 104 and the drain 105 are avoided from being corroded.
(3) Upon completion of manufacturing the metal oxide semiconductor layer 103 and prior to manufacturing the first insulator layer, the metal oxide semiconductor layer 103 is annealed, and then the metal oxide semiconductor layer 103, which functions as an active layer, is supplemented with oxygen. During the oxygen supplementation process, the oxygen-rich first insulator layer 106 facilitates improving the efficiency and quality of injecting oxygen.
(4) The function of the first insulator layer 106 includes: reducing surface defects of the metal oxide semiconductor layer 103 and serving as a protective layer to prevent the hydrogen atoms in an upper silicon nitride film layer from injecting into the metal oxide semiconductor layer 103.

It should be noted that prior to the formation of the first insulator layer 106, the metal oxide semiconductor layer 103 is annealed to remove the hydrogen atoms and unstable chemical bonds in the metal oxide semiconductor layer 103. An oxygen supplementation layer is formed on the first insulator layer 106 upon the formation of the first insulator layer 106 and prior to the formation of the second insulator film 107 to supplement oxygen to the metal oxide semiconductor layer 103, such that the risk of the metal oxide semiconductor layer 103 being conductive is reduced, and the semiconductor characteristic of the metal oxide semiconductor layer 103 is regulated. The oxygen supplementation layer is made of indium gallium zinc oxide (IGZO), and the oxygen supplementation process is to perform high-temperature annealing on the IGZO functioning as an oxygen supplementation layer, such that the oxygen atoms pass through the first insulator layer 106 and then enter the metal oxide semiconductor layer 103.

In summary, some embodiments of the present disclosure provide a metal oxide thin film transistor. Due to the high oxygen content of the first insulator layer of the metal oxide thin film transistor, the oxygen in the first insulator layer is capable of diffusing into the metal oxide semiconductor layer to supplement oxygen to the metal oxide semiconductor layer, such that the stability of the metal oxide thin film transistor is improved. Moreover, the first insulator layer is match with an interface of the metal oxide semiconductor layer, which reduces the surface defects of the metal oxide semiconductor layer. At the same time, the atomic percentage of oxygen contained in the metal oxide semiconductor layer is greater than 45%, such that the oxygen vacancies within the metal oxide semiconductor layer are not too much, which is not likely to cause the negative bias of the characteristics of the metal oxide thin film transistor during the operation of the TFT device, such that the sand point defects of the product caused by the negative bias of the characteristics of the metal oxide thin film transistors are effectively solved.

FIG. 3 is a schematic diagram of a curve of a percentage of each element in a first insulator layer, a metal oxide semiconductor layer, and a gate insulator layer according to some embodiments of the present disclosure. Referring to FIG. 3, the atomic percentage of oxygen contained in the metal oxide semiconductor layer 103 is greater than 50%.

The atomic percentage of oxygen, which is greater than 50%, avoids causing the negative bias of the characteristics of the metal oxide thin film transistor during the operation of the device, such that the sand point defects of the product caused by the negative bias of the characteristics of the metal oxide thin film transistor are avoided.

In some embodiments, the gate insulator layer 102 includes a first sub-gate insulator layer and a second sub-gate insulator layer that are successively stacked along the direction away from the base substrate 20 (facing the metal oxide semiconductor layer). The first sub-gate insulator layer is made of silicon nitride (SiNx), and the second sub-gate insulator layer is made of silicon oxide.

In some embodiments, a thickness of the first insulator layer 106 is less than 2000 Å (angstroms). This thickness has the following advantages.
(1) Because the second insulator layer (e.g., SiN) needs to be prepared on the first insulator layer (a silicon oxide film layer) 106, a pixel electrode needs to be formed after the formation of the first insulator layer and the second insulator layer and connected to the drain through a via in the first insulator layer and the second insulator layer. The via in the insulator layers needs to be formed by an etching solution. Because an etch rate of SiN is greater than an etch rate of SiO, SiO is made thinner to effectively increase the productivity and reduce the manufacturing cost of the product.
(2) The thickness of the first insulator layer 106 is less than 2000 Å, which is advantageous for, compared with the thickness in the related art of more than 2000 Å, directly injecting oxygen from the first insulator layer 106 into the metal oxide semiconductor layer 103. In the case that the film layer is thick, when the oxygen is injected from the oxygen supplementation layer (IGZO) of an upper surface layer of the first insulator layer 106 to a lower surface layer and enters into the metal oxide semiconductor layer 103, the oxygen injection efficiency and quality are relatively poor.
(3) The thickness of the first insulator layer 106 of less than 2000 Å prevents cracks from occurring at the source 104 or the drain. In the case that the high-temperature annealing is performed on the first insulator layer 106 with a large thickness, due to the large thickness and a high internal stress of the first insulator layer 106, cracks occur in a region where the first insulator layer 106 is overlapped with the source 104 or the drain 105. In particular, the cracks are prone to occurring at a sidewall of the source 104 or the drain 105 with a large thickness. Because the cracks expose the source 104 or the drain 105, the occurrence of the cracks directly cause the source 104 or the drain 105 to be oxidized or even corroded. Moreover, the hydrogen in a film layer above the source 104 or the drain enters a surface of the metal oxide semiconductor layer 103 that is in contact with the source 104 or the drain 105 through the source 104 or the drain 105, leading to a deterioration of the characteristics of the metal oxide thin film transistor, and in severe cases, leading to sand point defects occur on the display panel.

In the above embodiments, the first insulator layer 106 is a thin film layer rich in oxygen, which ensures a better oxygen injection effect and quality, effectively improves the productivity, and avoids the crack defects of the first insulator layer 106.

In some embodiments, when testing the silicon-oxygen bond (Si-O) of the first insulator layer 106 using the Fourier transform infrared spectroscopy (FTIR), a peak value of bond energy of the silicon-oxygen bond ranges from 1060 cm⁻¹ to 1080 cm⁻¹. For example, when testing the oxygen bonds (Si-O) of the first insulator layer 106 using the FTIR, the peak value of the bond energy of the silicon-oxygen bond ranges from 1063 cm⁻¹ to 1067 cm⁻¹, wherein cm⁻¹ indicates the number of waves in 1 centimeter. The peak value of the bond energy of the silicon-oxygen bond indicates a value of the bond energy at a maximum absorbance.

The large bond energy of the silicon-oxygen bond (Si-O) in the embodiments sufficiently indicates that the first insulator layer is a film layer rich in Si-O.

In some embodiments, the first insulator layer 106 is formed on the base substrate 20 using a chemical vapor deposition device. The gas used to manufacture the first insulator layer 106 contains dinitrogen oxide (N₂O) and silicon tetrahydroxide (SiH₄). The N₂O and SiH₄ react and deposit to form silicon oxide. That is, the first insulator layer 106 is a single-layered silicon oxide film layer.

It should be noted that each of the film layers of the metal oxide thin film transistor 10 is prepared within a reaction chamber. During the formation of the first insulator layer 106, N₂O and SiH₄ are introduced into the reaction chamber.

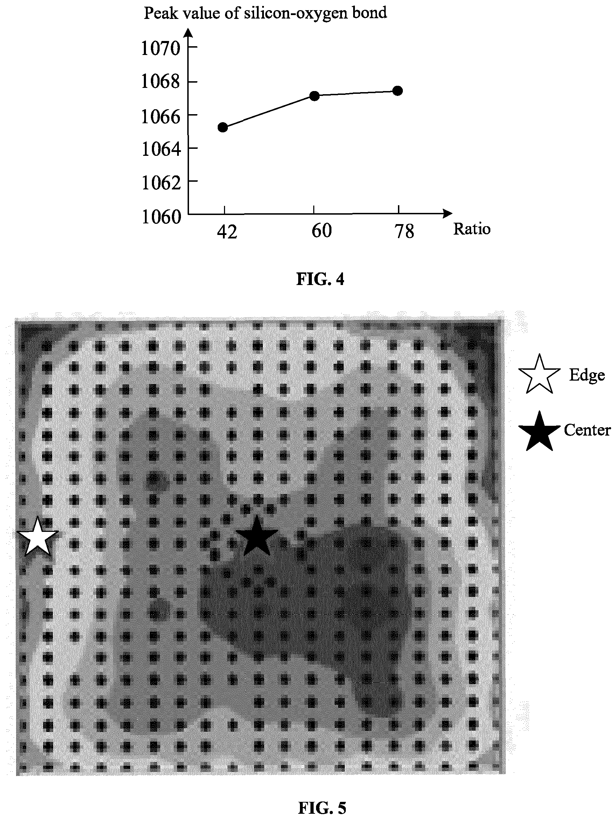

Referring to FIG. 4, a content ratio of N₂O to SiH₄ is designed to be large, such that the peak value of the bond energy of the silicon-oxygen bond in the prepared first insulator layer 106 reaches a range from 1060 cm⁻¹ to 1080 cm⁻¹ during the FTIR test, and thus the oxygen-rich film layer is achieved. Typically, in the case that the peak value of the bond energy of Si-O is up to 1060 cm⁻¹ or more, the oxygen content in the film layer (the first insulator layer 106) is higher than in conventional practices.

In some embodiments, the content of SiH₄ or hydrogen needs to be controlled when achieving the oxygen-rich first insulator layer 106. That is, the hydrogen content is few when the oxygen is rich, or a content ratio of oxygen to hydrogen is great and a content percentage of hydrogen is small.

An atomic percentage of hydrogen contained in the silicon oxide film layer in the first insulator layer 106 is less than 3%. A percentage of silicon-hydrogen bonds (Si-H) in the silicon oxide film layer in this first insulator layer 106 is less than 7%. The percentage of silicon-hydrogen bonds in the silicon oxide film layer is a ratio of the number of silicon-hydrogen bonds to the sum of the number of silicon-hydrogen bonds and the number of silicon-oxygen bonds.

As a result, due to the few content of hydrogen in the silicon oxide film layer of the first insulator layer 106, the hydrogen atoms in the first insulator layer 106 are prevented from excessively diffusing toward a direction from the first insulator layer 106 to the metal oxide semiconductor layer 103, such that the characteristics of the metal oxide thin film transistor are ensured not to be negatively biased.

In some embodiments, the display panel is prepared on a large-sized base substrate, and a plurality of display panels are acquired by cutting the large-size base substrate. FIG. 5 is a schematic diagram of a test of forming a first insulator layer on a large-sized base substrate according to some embodiments of the present disclosure. FIG. 5 is used to test atomic percentages of hydrogen of the first insulator layer formed on the large-sized base substrate in a center region and an edge region of the large-sized base substrate, and peak values of the bond energy of the silicon-oxygen bonds of the first insulator layer formed on the large-sized base substrate in the center region and the edge region of the large-sized base substrate.

Referring to Table 1 below, the atomic percentage of hydrogen of the first insulator layer 106 in the center region of the large-sized base substrate is 2.9%, and the atomic percentage of hydrogen of the first insulator layer 106 in the center region of the large-sized base substrate is 4.1%.

**Table 1**

| Test position | Peak value of the bond energy of the silicon-oxygen bond | Atomic percentage of hydrogen (H%) |
|---|---|---|
| Center region | 1060 | 2.9% |
| Edge region | 1053 | 4.1% |

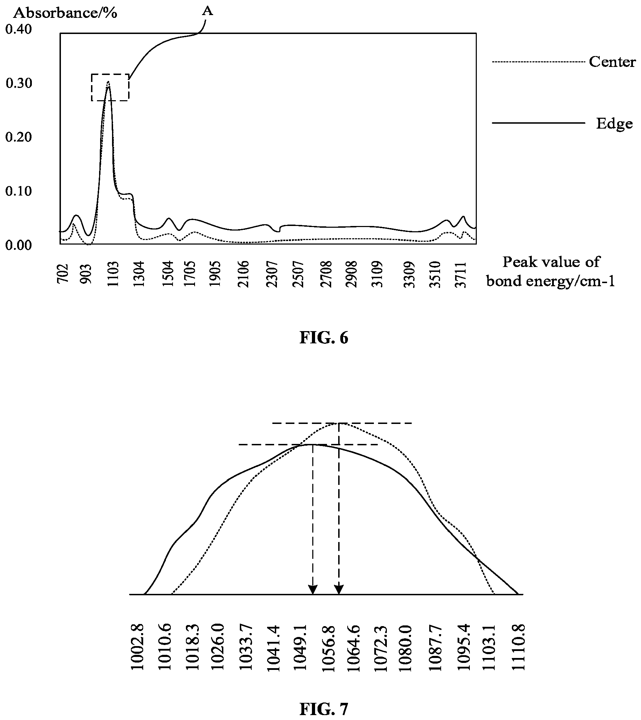

In addition, referring to Table 1 and FIG. 6, the peak value of the bond energy of the silicon-oxygen bond of the first insulator layer formed on the large-sized base substrate in the center region of the large-sized base substrate is 1060 cm⁻¹. The peak value of the bond energy of the silicon-oxygen bond of the first insulator layer formed on the large-sized base substrate in the edge region of the large-sized base substrate is 1053 cm⁻¹.\

According to the test results of the peak value of the bond energy of the silicon-oxygen bond and the atomic percentage of hydrogen, the peak value of the bond energy of the silicon-oxygen bond in the center region is larger than the peak value of the bond energy of the silicon-oxygen bond in the edge region, and the atomic percentage of hydrogen in the center region is smaller than the atomic percentage of hydrogen in the edge region (the atomic percentage of hydrogen in the center region is less than 3%, and the atomic percentage of hydrogen in the edge region is greater than 3%). When the first insulator layer is formed on the large-sized base substrate, the film quality of the first insulator layer in the center region is better than the film quality of the first insulator layer in the edge region. In other words, the smaller the size of the large-sized base substrate during preparation, the higher the quality of the first insulator layer is acquired. As a result, a small-sized base substrate is employed to manufacture a small number of display panels at one time under the premise of ensuring the productivity.

The first insulator layers 106 in the different regions of the present disclosure are formed by a one-time process, the Si contents are the same in the different regions, and the hydrogen and oxygen contents are different. In the case that the hydrogen content is larger, the sand point defects are serious. In the case that the oxygen content is larger, which means the hydrogen content is few, the sand point defects are effectively improved.

In some embodiments, the first insulator layer 106 is prepared in the reaction chamber. The first insulator layer 106 is a silicon oxide-based film layer formed by controlling the content of oxygen introduced into the reaction chamber during the deposition process. The atomic percentages of oxygen at a plurality of test positions in a thickness direction of the first insulator layer 106 are theoretically consistent but are different in actual tests. The differences do not exceed ±3%, and a difference between a maximum value and a minimum value does not exceed 5%.

That is, the atomic percentages of oxygen at various test positions in the thickness direction of the first insulator layer 106 remain substantially within a value fluctuation range (i.e., a maximum difference does not exceed 5%). As illustrated in FIG. 3, the curve of the atomic percentage of oxygen is wavy on the microscopic level and close to a straight line on the macroscopic level.

In some embodiments, the first insulator layer 106 includes a first surface and second surface that are opposite to each other. The first surface is a surface proximal to the metal oxide semiconductor layer 103, and the second surface is a surface distal from the metal oxide semiconductor layer 103. In a plurality of test positions from the second surface to the first surface, the closer the position is to the second surface, the greater is the difference between the atomic percentages of oxygen at every two adjacent test positions; and the closer the position is to the first surface, the smaller is the difference between the atomic percentages of oxygen at every two adjacent test positions.

Referring to FIG. 3, in the curve of the atomic percentage of oxygen at each test position in the thickness direction of the first insulator layer 106, the farther away from the metal oxide semiconductor layer 103, the curve that is further away from the metal oxide semiconductor layer (the curve closer to the left within the 106 range in FIG. 3) fluctuates more, and the curve that is more proximal to the metal oxide semiconductor layer (the curve closer to the right within the 106 range in FIG. 3) fluctuates less.

The test position is a position of the first insulator layer 106 in the thickness direction. Adjacent two test positions are adjacent positions of the first insulator layer 106 in the thickness direction. Referring to FIG. 3, the curve of the atomic percentage of oxygen at each test position in the thickness direction of the first insulator layer 106 is continuous, and thus the test positions of the first insulator layer 106 in the thickness direction are also continuous.

Moreover, when testing the number of oxygen atoms at the various test positions in the thickness direction of the first insulator layer 106, the test is directly performed on an outer wall of the first insulator layer 106 after the formation of the first insulator layer 106, or the test is performed on a sidewall of the first insulator layer 106 acquired by cutting the first insulator layer 106 along the thickness direction of the first insulator layer 106, which is not limited herein.

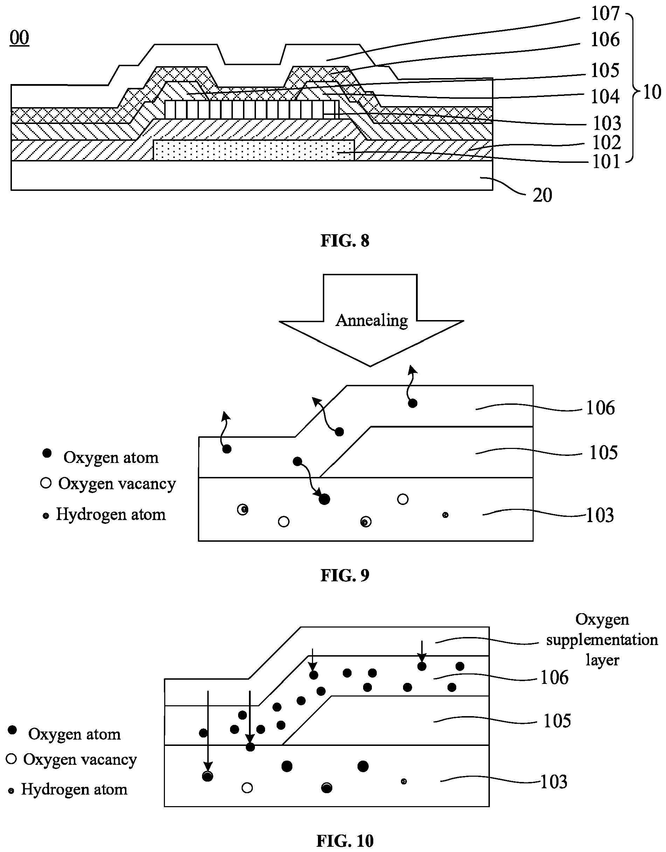

FIG. 8 is a schematic structural diagram of another display panel according to some embodiments of the present disclosure. Referring to FIG. 8, the metal oxide thin film transistor 10 further includes a second insulator film 107. The second insulator film 107 is disposed on a side, distal from the metal oxide semiconductor layer 103, of the first insulator layer 106. The second insulator film 107 contains silicon and further contains at least one of oxygen and nitrogen (N).

Because the second insulator film 107 is disposed on a side, distal from the gate 101, of the first insulator layer 106, the second insulator film 107 functions as a barrier. For example, the second insulator film 107 blocks external impurities, such as hydrogen or oxygen, from entering a key film layer through the second insulator film 107. The key film layer is a film layer disposed on a side, proximal to the gate 101, of the second insulator film 107. For example, the key film layer includes the first insulator layer 106, the source 104, the drain 105, and the metal oxide semiconductor layer 103.

In some embodiments, the first insulator layer 106 is a single-layered silicon oxide film layer. The single-layered silicon oxide film layer is a film layer with the same film quality prepared using the same process condition.

In some embodiments, the second insulator film 107 includes only a silicon oxide film layer, or includes only a silicon nitride film layer, or includes a silicon oxide film layer and a silicon nitride film layer that are successively stacked on a side of the first insulator layer 106, or includes a silicon oxide film layer, a silicon oxynitride film layer, and a silicon nitride film layer that are successively stacked on a side of the first insulator layer 106.

In some small and middle-sized embodiments, an organic resin is provided between the first insulator layer 106 and the second insulator film 107. As an optional implementation, in the case that the second insulator film 107 includes only a silicon nitride film layer, the first insulator layer 106 and the second insulator film 107 are differentiated based on the material of their film layer. The second insulator film 107 expels the hydrogen from the silicon nitride film layer during the high-temperature annealing process.

Exemplarily, in the case that the characteristics of the metal oxide thin film transistor satisfy the basic requirements, the silicon nitride film layer is formed directly on the first insulator layer 106 (the first insulator layer 106 is a single-layered silicon oxide film layer) to increase the productivity and reduce the cost.

As another optional implementation, in the case that there is a high requirement for the characteristics of the metal oxide thin film transistor, a second silicon oxide film layer whose film quality is different from that of the first silicon oxide film layer is provided on the first insulator film 106 (the first insulator layer 106 is a single-layered silicon oxide film layer, which is referred to as the first silicon oxide film layer). Moreover, a silicon nitride film layer is provided on a side, distal form the first insulator layer 106, of the second silicon oxide film layer. Both the second silicon oxide film layer and the silicon nitride film layer belong to the second insulator film 107.

It should be noted that the difference between the film qualities of the first silicon oxide film layer and the second silicon oxide film layer includes at least one of a greater difference between an atomic percentage of oxygen in the first silicon oxide film layer and an atomic percentage of oxygen in the second silicon oxide film layer, a great difference between a deposition rate when forming the first silicon oxide film layer and a deposition rate when forming the second silicon oxide film layer, and a great difference between a density of the first silicon oxide film layer and a density of the second silicon oxide film layer.

Exemplarily, the atomic percentage of oxygen in the silicon oxide film layer of the second insulator film 107 does not exceed the atomic percentage of oxygen in the silicon oxide film layer of the first insulator layer 106. The difference between the two atomic percentages is greater than 5% to 15%, such as 10%.

In some embodiments, a thickness of the silicon oxide film layer of the second insulator film 107 is greater than a thickness of the first insulator layer 106. For example, the thickness of the silicon oxide film layer of the second insulator film 107 is 3000 Å. The thickness of the silicon nitride film layer of the second insulator film 107 is 1000 Å.

If the metal oxide semiconductor layer 103 is supplemented with oxygen by the oxygen supplementation layer upon the formation of the first insulator layer 106 (the first silicon oxide film layer) and prior to the formation of the second silicon oxide film layer, the second silicon oxide film layer is used to improve an interface between the silicon nitride film layer and the first silicon oxide film layer, preventing the hydrogen in the silicon nitride film layer from entering the second region of the metal oxide semiconductor layer 103 that is not overlapped with either the source 104 or the drain 105, or entering an interface of the source 104 or the drain 105 that is in contact with the metal oxide semiconductor layer 103. That is, the second silicon film layer in the second insulator film 107 is a transition film layer, which mainly functions as a key film layer to improve the interface and prevent the hydrogen or water vapor from entering the metal oxide thin film transistor.

The second insulator film 107 expels the hydrogen contained in the silicon nitride film layer during the high-temperature annealing process, and supplements the oxygen from the first insulator layer 106 into the metal oxide semiconductor layer 103.

As yet another optional implementation, the second insulator film 107 includes a silicon oxide film layer, a silicon oxynitride film layer, and a silicon nitride film layer that are stacked on a side of the first insulator layer 106.

In the implementation, the function of the silicon oxide film layer of the second insulator film 107 is the same as the function of the second silicon oxide film layer in the previous implementation. The second insulator film 107 expels the silicon oxynitride contained therein and the hydrogen contained in the silicon nitride film layer during the high-temperature annealing process, and supplements the oxygen from the first insulator layer 106 into the metal oxide semiconductor layer 103.

An atomic ratio of silicon to oxygen in the silicon oxide film layer of the second insulator film 107 is 33:67. That is, Si: O=33:67. An atomic ratio of silicon to oxygen to nitrogen in the silicon oxynitride film layer of the second insulator film 107 is 36:52:12. That is, Si: O: N=36:52:12. An atomic ratio of silicon to nitrogen in the silicon nitride film layer of the second insulator film 107 is 51:49. That is, Si: N=51:49.

In some embodiments, the thickness of the silicon oxide film layer of the second insulator film 107 is greater than the thickness of the first insulator layer 106. For example, the thickness of the silicon oxide film layer of the second insulator film 107 is 3000 Å. A thickness of the silicon oxynitride film layer in the second insulator film 107 is 1000 Å. The thickness of the silicon nitride film layer of the second insulator film 107 is 1000 Å.

In the art, the first insulator layer 106 and the second insulator film 107 are referred to as passivation layers (PVX). That is, the first insulator layer 106 is referred to as a first passivation layer, and the second insulator film 107 is referred to as a second passivation layer.

Typically, a thickness of the first passivation layer 106 in the related art ranges from 3000 Å to 5000 Å. The first passivation layer 106 is capable of preventing the external hydrogen from entering the key film layer. However, the thickness of the first passivation layer 106 in the embodiments of the present disclosure is less than 2000 Å, which facilitates the oxygen supplementation to the metal oxide semiconductor layer 103 and reduces the surface defects of the metal oxide semiconductor layer 103.

Moreover, a main film layer in the embodiments of the present disclosure that prevents the external hydrogen from entering the key film layer is the second passivation layer 107. The structure of the second passivation layer 107 is the same as the structure as described above. That is, the first passivation layer 106 (a single-layered silicon oxide film layer with a thickness of less than 2000 Å) in the embodiments of the present disclosure is not equivalent to the first passivation layer (a silicon oxide film layer with a thickness ranging from 3000 Å to 5000 Å) in the related art.

In some embodiments, because the first insulator layer 106 is a single-layered silicon oxide film layer, the first insulator layer 106 is a film layer with the same film quality prepared using the same process condition. As a result, the first insulator layer 106 has the same density at a plurality of test positions along the thickness direction of the first insulator layer 106. The first insulator layer 106 having the same density at the plurality of test positions along the thickness direction of the first insulator layer 106 indicates that the densities at the plurality of test positions of the first insulator layer 106 along the thickness direction of the first insulator layer 106 are exactly the same; or the densities at the plurality of test positions of the first insulator layer 106 along the thickness direction of the first insulator layer 106 are within an error range. For example, differences between the densities at the plurality of test positions of the first insulator layer 106 along the thickness direction of the first insulator layer 106 do not exceed 5%.

In some embodiments, in the first insulator layer 106, densities at every adjacent two test positions closer to the first surface and densities at every adjacent two test positions closer to the second surface are different from a density of a region between the first surface and the second surface of the first insulator layer 106. For example, the difference between the densities at every adjacent two test positions closer to the first surface and the density of the region between the first surface and the second surface of the first insulator layer 106, and the difference between the densities at every adjacent two test positions closer to the second surface and the density of the region between the first surface and the second surface of the first insulator layer 106 range from 0% to 5%.

It should be noted that differences between the atomic percentages of oxygen at the plurality of test positions along the thickness direction of the first insulator layer 106 do not exceed 5%, and the same density at the plurality of test positions indicates that the first insulator layer 106 is a single-layered film layer.

In some embodiments, the density of the first insulator layer 106 is less than the density of the second insulator film 107. Due to the small density of the first insulator layer 106, the first insulator layer 106 is looser than the second insulator film 107. Therefore, it is easier to supplement oxygen to the metal oxide semiconductor layer 103 after the formation of the first insulator layer 106 and before the formation of the second insulator film 107. At the same time, because the second insulator film 107 is dense, during the high-temperature annealing process after the formation of the second insulator film 107, the oxygen in the metal oxide semiconductor layer 103 easily escapes and is trapped inside the first insulator layer 106 instead of being easily released to the outside through the second insulator film 107, which is beneficial for the first insulator layer 106 to supplement the metal oxide semiconductor layer 103 with oxygen again, and avoids the poor characteristics of the metal oxide thin film transistor caused by a large concentration of the hydrogen in the metal oxide semiconductor layer 103 and its vicinity.

The density of the film layer is negatively correlated with a deposition rate of the film layer. That is, the higher the deposition rate of the film layer, the lower the density of the film layer; and the lower the deposition rate of the film layer, the higher the density of the film layer. Thus, a deposition rate of the first insulator layer 106 is greater than a deposition rate of the second insulator film 107, such that the density of the first insulator layer 106 is less than the density of the second insulator film 107.

In some embodiments, the deposition rate of the first insulator layer 106 is 10 Å/s. Exemplarily, the deposition rate of the first insulator layer 106 does not exceed 16 Å/s. The deposition rate of the silicon oxide film layer of the second insulator film 107 is greater than the deposition rate of the first insulator layer 106, and ranges, for example, from 12 Å/s to 15 Å/s.

The thickness of the silicon oxide film layer of the second insulator film 107 is greater than the thickness of the first insulator layer 106. Therefore, to increase the efficiency in manufacturing the second insulator film 107, the deposition rate of the silicon oxide film layer of the second insulator film 107 is made to be greater than the deposition rate of the first insulator layer 106.

It should be noted that in the case that the density of the first insulator layer 106 is less than the density of the second insulator film 107, the density of the first insulator layer 106 is less than the density of the silicon nitride film layer of the second insulator film 107.

Referring to FIG. 9, the metal oxide semiconductor layer 103 requires to expel the hydrogen after its formation, which is performed, for example, by an annealing treatment. The annealing treatment also causes the metal oxide semiconductor layer 103 to lose a portion of oxygen atoms. Therefore, referring to FIG. 10, to ensure a sufficient oxygen concentration in the metal oxide semiconductor layer 103 after the metal oxide thin film transistor has been manufactured to avoid the metal oxide semiconductor layer 103 being conductive, it is necessary to effectively supplement oxygen to the metal oxide semiconductor layer 103 after the first insulator layer 106 is formed. After the formation of the first insulator layer 106 and before the formation of the second insulator film 107, an oxygen supplementation layer is formed on a side, distal from the gate 101, of the first insulator layer 106 (the oxygen supplementation layer needs to be removed after the oxygen supplementation is completed, and the oxygen supplementation layer is made of indium gallium zinc oxide).

The process of oxygen supplementation is that the oxygen in the oxygen supplementation layer diffuses to the metal oxide semiconductor layer 103 through the first insulator layer 106. The oxygen needs to diffuse to the metal oxide semiconductor layer 10 through the first insulator layer 106, it is necessary to design the first insulator layer 106 to be looser (i.e., the density of the first insulator layer 106 needs to be small). Thus, in some embodiments, the deposition rate of the first insulator layer 106 is designed to be large (e.g., greater than 10 Å/s), such that the loose first insulator layer 106 is prepared, and thus the oxygen in the oxygen supplementation layer diffuses to the metal oxide semiconductor layer 103 through the loose first insulator layer 106. In this way, the number of oxygen vacancies in the metal oxide semiconductor layer 103 is reduced, and the stability of the metal oxide thin film transistor 10 is improved.

For clearer illustration of the oxygen supplementation process to the metal oxide semiconductor layer 103 of the metal oxide thin film transistor 10, FIG. 2, FIG. 9, and FIG. 10 only illustrate the metal oxide semiconductor layer 103, the drain 105, and the first insulator layer 106.

In some embodiments, the density (i.e., the degree of sparsity) of the first insulator layer 106 is characterized using an etch rate of the first insulator layer 106 when being etched by a hydrogen fluoride (HF) solution. The faster the etch rate, the smaller the density of the first insulator layer 106 (i.e., the looser the first insulator layer 106); and the slower the etch rate, the larger the density of the first insulator layer 106 (i.e., the denser the first insulator layer 106).

In some embodiments, the etch rate exceeds 25 Å/S and does not exceed 40 Å/S during etching of the first insulator layer 106 using the HF solution. For example, the etch rate ranges from 28 Å/S to 35 Å/S during etching of the first insulator layer 106 using the HF solution.

Typically, in the case that the etch rate is greater than 20 Å/S during etching of the film layer using the HF solution, the film layer is considered to be loose. However, in some embodiments, in the case that an etch rate is 25 Å/S during etching of the first insulator layer 106 using the HF solution, the density of the first insulator layer 106 is small.

By designing the loose first insulator layer 106, it is convenient to form the oxygen supplementation layer on the side, distal from the gate 101, of the first insulator layer 106 to supplement oxygen to the metal oxide semiconductor layer 103.

In some embodiments, a ratio of a thickness of the first insulator layer 106 to a thickness of the second insulator film 107 ranges from 0.2 to 0.5. Exemplarily, the thickness of the first insulator layer 106 (a single-layered silicon oxide layer) is 1000 Å. The second insulator film 107 includes a silicon oxide film layer and a silicon nitride film layer that are successively stacked on the first insulator layer 106. In the second insulator film 107, a thickness of the silicon oxide film layer is 3000 Å and a thickness of the silicon nitride film layer is 1000 Å. That is, the thickness of the second insulator film 107 is 4000 Å. The ratio of the thickness of the first insulator layer 106 to the thickness of the second insulator film 107 is 1000/4000=0.25.

Because the ratio of the thickness of the first insulator layer 106 to the thickness of the second insulator film 107 is small, the first insulator layer 106 is thin.

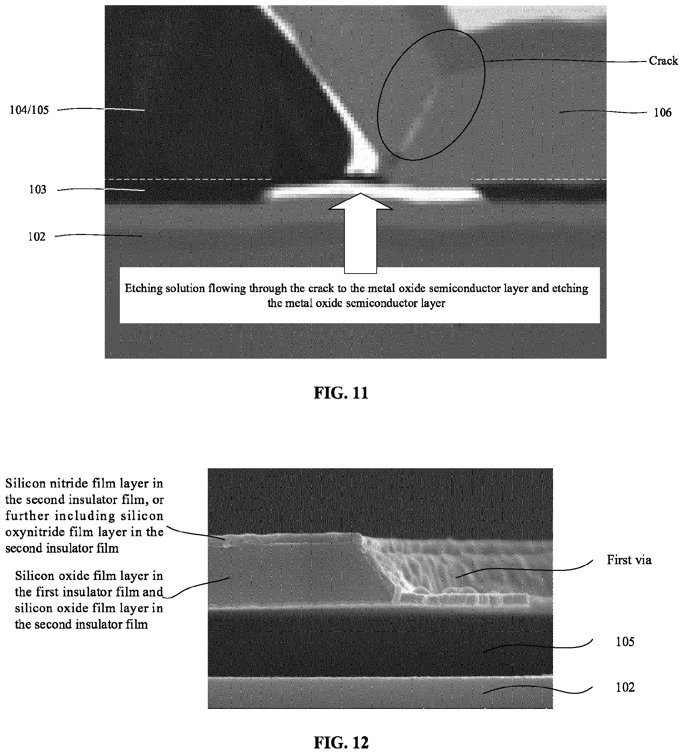

In some embodiments, in the case that the thickness of the first insulator layer 106 is small (e.g., the thickness is less than 500 Å), the metal oxide semiconductor layer 103 is susceptible to being conductive, and the performance of the metal oxide thin film transistor 10 is poor. In the case that the thickness of the first insulator layer 106 is large (e.g., greater than 2000 Å), referring to FIG. 11, the first insulator layer 106 is prone to cracking due to the high film pressure of the first insulator layer 106. The crack exposes the source 104 or the drain 105, and thus the occurrence of the crack causes the etch solution to flow to the metal oxide semiconductor layer 103 through the crack, which has etched the metal oxide semiconductor layer 103, leading to a deterioration of the characteristics of the metal oxide thin film transistor, and in severe cases, leading to sand point defect occur on the display panel. In the two white dashed lines illustrated in FIG. 11, the white dashed line on the left side is a boundary line between the source 104 or the drain 105 and the metal oxide semiconductor layer 103, and the white dashed line on the right side is a boundary line between the first insulator layer 106 and the metal oxide semiconductor layer 103.

As a result, the thickness of the first insulator layer 106 in the metal oxide thin film transistor 10 according to some embodiments of the present disclosure ranges from 500 Å to 2000 Å. In one aspect, the metal oxide semiconductor layer 103 is prevented from being susceptible to being conductive, which ensures the performance of the metal oxide thin film transistor 10; and in another aspect, the crack is prevented from occurring in the first insulator layer 106, which ensures the yield of the metal oxide thin film transistor 10. Exemplarily, the thickness of the first insulator layer 106 is greater than 500Å and less than 1100 Å.

Referring to FIG. 12, the first insulator layer 106 and the second insulator film 107 have first vias. The first via is configured to expose the drain 105, such that a pixel unit subsequently formed on a side, distal from the gate 101, of the second insulator film 107 is electrically connected to the drain 105 through the first via.

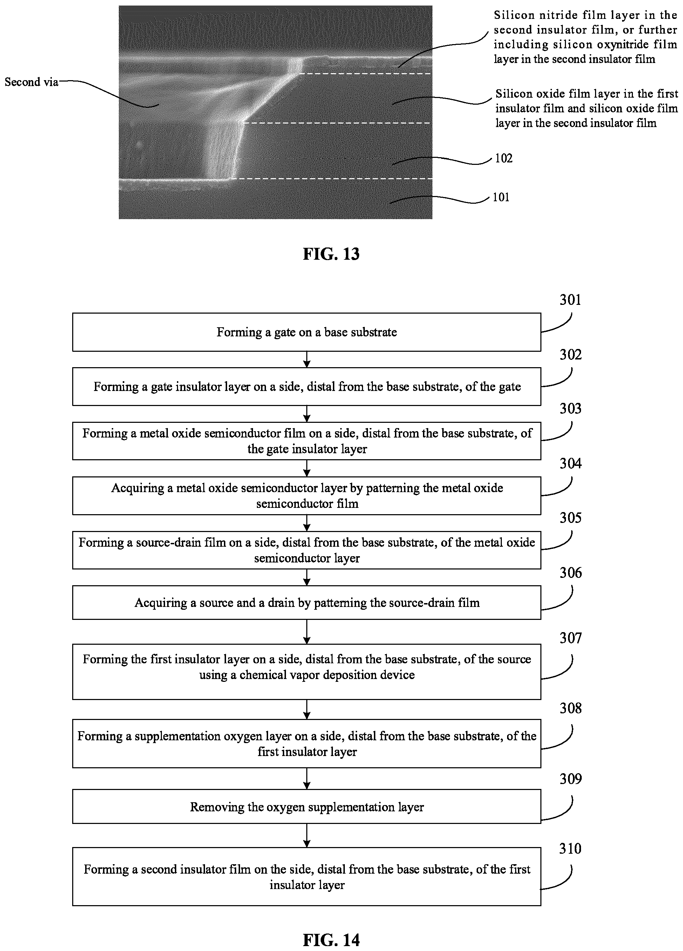

Referring to FIG. 13, the gate insulator layer 102, the first insulator layer 106, and the second insulator film 107 have a second via. The second via is configured to expose the gate 101, such that a common electrode subsequently formed on the side, distal from the gate 101, of the second insulator film 107 is electrically connected to the gate 101 through the second via.

In FIG. 12 and FIG. 13, the term "silicon oxide film layer in the second insulator film, or further including a silicon nitride film layer in the second insulator film" indicates that in the case that the second insulator film 107 includes a silicon oxide film layer and a silicon nitride film layer, the layer is the silicon nitride film layer of the second insulator film; and in the case that the second insulator film 107 includes a silicon oxide film layer, a silicon oxynitride film layer, and a silicon nitride film layer, the layer is the silicon oxynitride film layer and the silicon nitride film layer of the second insulator film. In the three white dashed lines illustrated in FIG. 13, the white dashed line on the bottom side indicates a boundary line between the gate 101 and the gate insulator layer 102, the white dashed line in the middle indicates a boundary line between the gate insulator layer 102 and the first insulator layer 106, and the white dashed line on the top side indicates a boundary line between the silicon oxide film layer of the second insulator film 107 and the silicon nitride film layer or the silicon oxynitride film layer of the second insulator film 107.

In some embodiments, a slope angle of the first via in the silicon oxide film layer of the first insulator layer 106 and the silicon oxide film layer of the second insulator film 107 ranges from 40 degrees to 60 degrees. A slope angle of the first via in the silicon nitride film layer of the second insulator film 107 ranges from 60 degrees to 70 degrees. Referring to FIG. 12, the slope angle of the first via in the silicon oxide film layer of the first insulator layer 106 and the silicon oxide film layer of the second insulator film 107 is substantially equal to the slope angle of the first via in the silicon nitride film layer of the second insulator film.

The slope angle of the first via in the silicon oxide film layer of the first insulator layer 106 and the silicon oxide film layer of the second insulator film 107 refers to an angle between a sidewall and a bottom surface of the first via in the silicon oxide film layer of the first insulator layer 106 and the silicon oxide film layer of the second insulator film 107. The slope angle of the first via in the silicon nitride film layer of the second insulator film 107 refers to an angle between a sidewall and a bottom surface of the first via in the silicon nitride film layer of the second insulator film 107.

In addition, a slope angle of the second via in the gate insulator layer 102 is greater than 80 degrees. A slope angle of the second via in the silicon oxide film layer of the first insulator layer 106 and the silicon oxide film layer of the second insulator film 107 ranges from 40 degrees to 60 degrees. A slope angle of the second via in the silicon nitride film layer of the second insulator film 107 is greater than 80 degrees.

The slope angle of the second via in the gate insulator layer 102 refers to an angle between a sidewall and a bottom surface of the second via of the gate insulator layer 102. The slope angle of the second via in the silicon oxide film layer of the first insulator layer 106 and the silicon oxide film layer of the second insulator film 107 refers to an angle between a sidewall and a bottom surface of the second via in the silicon oxide film layer of the first insulator layer 106 and the silicon oxide film layer of the second insulator film 107. The slope angle of the second via in the silicon nitride film layer of the second insulator film 107 refers to an angle between a sidewall and a bottom surface of the second via in the silicon nitride film layer of the second insulator film 107.

In some embodiments of the present disclosure, the thickness of the source 104 and the thickness of the drain 105 are greater than 3000 Å and less than 6000 Å, and slope angles of both the source 104 and the drain 105 are less than 60° (degrees). By designing the slope angle of the source 104 and the slope angle of the drain 105 to be small, the first insulator layer 106 formed on a side, distal from the base substrate 20, of the source 104 and the drain 105 is avoided from cracking at a climb of the source 104 and at a climb of the drain 105, and thus the yield of the metal oxide thin film transistor 10 is ensured.

The slope angle of the source 104 refers to an angle between a sidewall of the source 104 and a surface, proximal to the gate 101, of the source 104. The slope angle of the drain 105 refers to an angle between a sidewall of the drain 105 and a surface, proximal to the gate 101, of the drain 105.

In some embodiments, the metal oxide semiconductor layer 103 includes a first surface and a second surface that are opposite to each other. The first surface is closer to the base substrate 20 relative to the second surface. A portion, proximal to the first surface, of the metal oxide semiconductor layer 103 contains amorphous or nano-crystalline metal oxide. A portion, proximal to the second surface, of the metal oxide semiconductor layer 103 contains C-axis crystallized metal oxide.

The amorphous or nano-crystalline metal oxide contains at least one of indium, gallium, zinc, tin, and praseodymium. The C-axis crystallized metal oxide contains at least one of indium, gallium, zinc, tin, and praseodymium.

In some embodiments, the amorphous or nano-crystalline metal oxide contains indium gallium zinc oxide. An atomic ratio of indium to gallium to zinc in the indium gallium zinc oxide is 4:2:3, 1:1:1, or 1:3:6. The atomic ratio of indium to gallium to zinc in the indium gallium zinc oxide refers to the number of indium atoms: the number of gallium atoms: the number of zinc atoms. For example, in the case that the atomic ratio is 4:2:3, the amorphous or nano-crystalline indium gallium zinc oxide is an amorphous or nano-crystalline In₄Ga₂Zn₃O_{X}.

Moreover, the C-axis crystallized metal oxide contains indium gallium zinc oxide. An atomic ratio of indium to gallium to zinc in the indium gallium zinc oxide is 4:2:3, 1:1:1, or 1:3:6. The atomic ratio of indium to gallium to zinc in the C-axis crystallized metal oxide refers to the number of indium atoms: the number of gallium atoms: the number of zinc atoms. For example, in the case that the atomic ratio is 4:2:3, the C-axis crystallized metal oxide is a C-axis crystallized metal oxide In₄Ga₂Zn₃O_{X}.

In some embodiments, the process of forming the metal oxide semiconductor layer 103 in the metal oxide thin film transistor 10 illustrated in FIG. 1 includes: forming the amorphous or nano-crystalline metal oxide on a side, distal from the gate 101, of the gate insulator layer 102 using a magnetron sputtering device, and thereafter forming C-axis crystallized metal oxide on a side, distal from the gate 101, of the amorphous or nano-crystalline metal oxide using a magnetron sputtering device.

In some embodiments, a thickness of the amorphous or nano-crystalline metal oxide ranges from 10 Å to 300 Å. A thickness of the C-axis crystallized metal oxide ranges from 10 Å to 400 Å.

In addition, a carrier mobility of a portion, proximal to the first surface, of the metal oxide semiconductor layer 103 (i.e., the amorphous or nano-crystalline metal oxide) ranges from 10 square centimeters per volt second (cm²/V•S) to 20 cm²/V•S. For example, the carrier mobility of the amorphous or nano-crystalline metal oxide is 15 cm²/V•S. Because the amorphous or nano-crystalline metal oxide has a large carrier mobility, the metal oxide thin film transistor has good electrical conductivity.

In summary, the embodiments of the present disclosure provide a metal oxide thin film transistor. Because the first insulator layer of the metal oxide thin film transistor has a high oxygen content, the oxygen in the first insulator layer is capable of diffusing into the metal oxide semiconductor layer, which achieves thee effect of oxygen supplementation to the metal oxide semiconductor layer, and thus the stability of the metal oxide thin film transistor is improved. Moreover, the metal oxide semiconductor layer is matched with the interface of the first insulator layer, which reduces surface defects of the metal oxide semiconductor layer. At the same time, the atomic percentage of oxygen contained in the metal oxide semiconductor layer is greater than 45%, such that the oxygen vacancies within the metal oxide semiconductor layer are not too much, which is not likely to cause the negative bias of the characteristics of the metal oxide thin film transistor when the device is operating, and the sand point defects of the product caused by the negative bias of the characteristics of the metal oxide thin film transistor are effectively reduced.

Some embodiments of the present disclosure further provide a method for manufacturing a metal oxide thin film transistor, which is employed to manufacture the metal oxide thin film transistor 10 illustrated in FIG. 1. The method includes: forming a gate 101, a gate insulator layer 102, a metal oxide semiconductor layer 103, a source 104, a drain 105, and a first insulator layer 106 on a base substrate 20. The source 104 and the drain 105 are prepared using the same one-time patterning process. That is, the source 104 and the drain 105 are disposed in the same layer.

Referring to FIG. 1, in the prepared metal oxide thin film transistor 10, the gate insulator layer 102, the metal oxide semiconductor layer 103, the source 104, and the first insulator layer 106 are successively stacked along a direction away from the gate 101. A side, proximal to the gat 101, of the first insulator layer 106 is at least partially in contact with the metal oxide semiconductor layer 103. Exemplarily, an orthographic projection of the metal oxide semiconductor layer 103 on the base substrate 20 includes a first region that is at least partially overlapped with the source 104 and the drain 105, and a second region that is not overlapped with either the source 104 or the drain 105. That is, a region, below the source 104 and the drain 105, of the metal oxide semiconductor layer 101 functioning as the first region, and a region, between the source 104 and the drain 105, functions as the second region. The side, proximal to the gate 101, of the first insulator layer 106 is in contact with a portion, in the second region, of the metal oxide semiconductor layer 103.

The first insulator layer 106 is an inorganic insulator layer containing at least the silicon and the oxygen. The first insulator layer 106 further contains a small number of nitrogen atoms in the actual test, but the number of nitrogen atoms accounts for a very small percentage. Therefore, the first insulator layer 106 is referred to as a silicon oxide film layer.

An atomic percentage of oxygen contained in the first insulator layer 106 is greater than 50%. In some embodiments, the atomic percentage of oxygen contained in the first insulator layer 106 ranges from 50% to 75%. Exemplarily, the atomic percentage of oxygen of the first insulator layer 106 is 55%, 60%, 65%, or 70%. That is, the oxygen content in the first insulator layer 106 is high and the first insulator layer 106 is an oxygen-rich film layer.

In some embodiments, an atomic percentage of oxygen contained in the metal oxide semiconductor layer is greater than 45%. The atomic percentage of oxygen contained in the metal oxide semiconductor layer 103 that is greater than 45% is data actually tested, such that oxygen vacancies within the metal oxide semiconductor layer 103 are not too much. In this way, it is not likely to cause a negative bias of characteristics of the metal oxide thin film transistor when the device is operating, and sand point defects of the product caused by the negative bias of the characteristics of the metal oxide thin film transistor are effectively reduced.

Referring to FIG. 2, due to a large mobility of the metal oxide semiconductor layer 103, the number of oxygen vacancies of the metal oxide semiconductor layer 103 in the metal oxide thin film transistor is large, and it is difficult to control the characteristics of the metal oxide thin film transistor. Therefore, by designing a large atomic percentage of oxygen contained in the first insulator layer 106, the oxygen atoms in the first insulator layer 106 diffuse into the metal oxide semiconductor layer 103, which achieves an effect of oxygen supplementation to the metal oxide semiconductor layer 103 (e.g., an oxygen supplementation layer is formed on the first insulator layer 106 after the formation of the first insulator layer 106 and prior to the formation of the second insulator film 107 to supplement oxygen to the metal oxide semiconductor layer 103), and thus the stability of the metal oxide thin film transistor is improved. The oxygen supplementation layer is made of IGZO.

In addition, the first insulator layer 106 is disposed on a side of the metal oxide semiconductor layer 103. A surface, proximal to the metal oxide semiconductor layer 103, of the first insulator layer 106 is matched with a surface, proximal to the first insulator layer 106, of the metal oxide semiconductor layer 103 (i.e., interface matching), which reduces surface defects of the metal oxide semiconductor layer 103.

The function of the first insulator layer 106 includes performing oxygen supplementation on the metal oxide semiconductor layer 103 and reducing the surface defects of the metal oxide semiconductor layer 103.

In summary, some embodiments of the present disclosure provide a method for manufacturing a metal oxide thin film transistor. Due to the high oxygen content of the first insulator layer of the metal oxide thin film transistor prepared by the method, the oxygen in the first insulator layer is capable of diffusing into the metal oxide semiconductor layer, which achieves the oxygen supplementation to the metal oxide semiconductor layer and further improves the stability of the metal oxide thin film transistor. Moreover, the first insulator layer is match with the interface of the metal oxide semiconductor layer, which reduces the surface defects of the metal oxide semiconductor layer. At the same time, the atomic percentage of oxygen in the metal oxide semiconductor layer is greater than 45%, such that the oxygen vacancies in the metal oxide semiconductor layer are not too much, which is not likely to cause a negative bias of characteristics of the metal oxide thin film transistor when the device is operating, and sand point defects of the product caused by the negative bias of the characteristics of the metal oxide thin film transistor are effected reduced.

FIG. 14 is a flowchart of a method for manufacturing a metal oxide thin film transistor according to some embodiments of the present disclosure. The method is employed to manufacture the metal oxide thin film transistor according to the above embodiments, for example, to manufacture the metal oxide thin film transistor illustrated in FIG. 1. Referring to FIG. 14, the method includes the following steps.

In step 301, a gate is formed on a base substrate.

In some embodiments, a base substrate 20 is acquired first, and a gate film is formed on a side of the base substrate 20, after which the gate 101 is acquired by patterning the gate film. The base substrate 20 is a glass substrate.

In step 302, a gate insulator layer is formed on a side, distal from the base substrate, of the gate.

In some embodiments, after forming the gate 101, the gate insulator layer 102 is formed on the side, distal from the base substrate 20, of the gate 101, such that the gate 101 is insulated from a source 104 and a drain 105 that are subsequently formed.

In some embodiments, the gate insulator layer 102 included a first sub-gate insulator layer 102 and a second sub-gate insulator layer 102 that are successively stacked along a direction away from the base substrate 20. The first sub-gate insulator layer 102 is made of silicon nitride, and the second sub-gate insulator layer 102 is made of silicon oxide.

In step 303, a metal oxide semiconductor film is formed on a side, distal from the base substrate, of the gate insulator layer.

After forming the gate insulator layer 102, the metal oxide semiconductor film is formed on the side, distal from the base substrate 20, of the gate insulator layer 102, and the metal oxide semiconductor film covers a whole layer of the base substrate 20.

In some embodiments, a first thin film is formed on the side, distal from the base substrate 20, of the gate insulator layer 102 using a magnetron sputtering device. The first thin film is prepared using a material with a high mobility. Afterward, a second thin film is formed on a side, distal from the base substrate 20, of the first thin film using a magnetron sputtering device. The first film and the second film are collectively referred to as a metal oxide semiconductor film.

The first film is amorphous or nano-crystalline metal oxide, and the second film is C-axis crystallized metal oxide. The amorphous or nano-crystalline metal oxide contains at least one of indium, gallium, zinc, tin, and praseodymium. The C-axis crystallized metal oxide contains at least one of indium, gallium, zinc, tin, and praseodymium.

In some embodiments, the amorphous or nano-crystalline metal oxide contains indium gallium zinc oxide. An atomic ratio of indium to, gallium to zinc in the indium gallium zinc oxide is 4:2:3, 1:1:1, or 1:3:6. The atomic ratio of indium to gallium to zinc in the amorphous or nano-crystalline indium gallium zinc oxide refers to the number of indium atoms: the number of gallium atoms: the number of zinc atoms. For example, in the case that the atomic ratio is 4:2:3, the amorphous or nano-crystalline indium gallium zinc oxide is amorphous or nano-crystalline In₄Ga₂Zn₃O_{X}.

In addition, the C-axis crystallized metal oxide contains indium gallium zinc oxide. An atomic ratio of indium to gallium to zinc in the indium gallium zinc oxide is 4:2:3, 1:1:1, or 1:3:6. The atomic ratio of indium to gallium to zinc in the C-axis crystallized indium gallium zinc oxide refers to the number of indium atoms: the number of gallium atoms: the number of zinc atoms. For example, in the case that the atomic ratio is 4:2:3, the C-axis crystallized indium gallium zinc oxide is C-axis crystallized In₄Ga₂Zn₃O_{X}.

In some embodiments, a thickness of the first film ranges from 10 Å to 300 Å. A thickness of the second film ranges from 10 Å to 400 Å.

In step 304, a metal oxide semiconductor layer is acquired by patterning the metal oxide semiconductor film.

In some embodiments, after forming the metal oxide semiconductor film, the metal oxide semiconductor layer 10 is acquired by patterning the metal oxide semiconductor film using a photolithography process. An orthographic projection of the metal oxide semiconductor layer 103 on the base substrate 20 is at least partially overlapped with an orthographic projection of the gate 101 on the base substrate 20. The photolithography process includes processes such as photoresist (PR) coating, exposure, development, etching, and photoresist stripping. The photolithography process is also referred to as a mask plate process.

In some embodiments, the metal oxide semiconductor film in step 303 above includes the first film and the second film. Patterning the metal oxide semiconductor film in step 304 refers to patterning the first film and the second film. By patterning the first film, the amorphous or nano-crystalline metal oxide, proximal to a first surface, in the metal oxide semiconductor layer 103 is acquired, and by patterning the second film, the C-axis crystallized metal oxide, proximal to a second surface, in the metal oxide semiconductor layer 103 is acquired. The first surface and the second surface are two opposite side surfaces of the metal oxide semiconductor layer 103, and the first surface is closer to the base substrate 20 relative to the second surface.

The amorphous or nano-crystalline metal oxide, proximal to the first surface, in the metal oxide semiconductor layer 103 has a high carrier mobility. In some embodiments, the carrier mobility of the amorphous or nano-crystalline, proximal to the first surface, of the metal oxide semiconductor layer 103 ranges from 10 cm²/V•S to 20 cm²/V•S. For example, the carrier mobility is 15 cm²/V•S.

In step 305, a source-drain film is formed on a side, distal from the base substrate, of the metal oxide semiconductor layer.

In some embodiments, after the metal oxide semiconductor layer 103 is prepared, the source-drain film is formed on the side, distal from the base substrate 20, of the metal oxide semiconductor layer 103. The source-drain film is made of a metallic material, and the source-drain film covers a whole layer of the base substrate 20.

In step 306, a source and a drain are acquired by patterning the source-drain film.

In some embodiments, after forming the source-drain film, the source 104 and the drain 105 are acquired by patterning the source-drain film using a photolithographic process. When etching the source-drain film, the source 104 and the drain 105 are acquired by using an etchant to perform a wet etch on the source-drain film. In the embodiments, the source 104 and the drain 105 are prepared using the same patterning process

An orthographic projection of the source 104 on the base substrate 20 is overlapped with an orthographic projection of the metal oxide semiconductor layer 103 on the base substrate 20. An orthographic projection of the drain 105 on the base substrate 20 is overlapped with the positive projection of the metal oxide semiconductor layer 103 on the base substrate 20.

Moreover, the thicknesses of the prepared source 104 and the drain 105 are greater than 3000 Å and less than 6000 Å. In addition, a sidewall, proximal to the drain 105, of the source 104 and a sidewall, proximal to the source 104, of the drain 105 are curved or folded. As a result, different regions of the sidewall, proximal to the drain 105, of the source 104 have different angles between a side surface, proximal to or distal from the first insulator layer 106, of the source 104, and different regions of the sidewall, proximal to the source 104, of the drain 105 have different angles between a side surface, proximal to or distal from the first insulator layer 106, of the drain 105.

Slope angles of the prepared source 104 and the drain 105 are both less than 60°. By designing the slope angle of the source 104 and the slope angle of the drain 105 to be smaller, the first insulator layer 106 formed on a side, distal from the gate 101, of the source 104 and the drain 105 is prevented from cracking at a climb of the source 104 and at a climb of the drain 105, which ensures the yield of the metal oxide thin film transistor 10.

In step 307, the first insulator layer is formed on a side, distal from the base substrate, of the source using a chemical vapor deposition device.

In some embodiments, each film layer of the metal oxide thin film transistor is prepared in a reaction chamber. During the formation of the first insulator layer 106, N₂O and SiH₄ are introduced into the reaction chamber. In some embodiments, a content ratio of N₂O to SiH₄ is greater than 78. Exemplarily, the content ratio of N₂O to SiH₄ is 80.

Referring to FIG. 4, by designing the content ratio of N₂O to SiH₄ to be large, a peak value of bond energy of a silicon-oxygen bond in the prepared first insulator layer 106 reaches a range from 1060 cm⁻¹ to 1080 cm⁻¹ in the FTIR test. Typically, in the case that the peak value of the bond energy Si-O bond is more than 1060 cm⁻¹, the oxygen content in the film layer (the first insulator layer 106) is high, such that the unstable characteristics of the metal oxide thin film transistor caused by the high content of impurities (e.g., hydrogen.) in the first insulator layer 106 is avoided.

In some embodiments, the first insulator layer 106 is prepared at a deposition rate of greater than 10 Å/s. Exemplarily, the first insulator layer 106 is prepared at the deposition rate of no more than 16 Å/s.

By designing the deposition rate of the first insulator layer 106 to be large, the formed first insulator layer 106 is loose (less dense), which facilitates the subsequent oxygen supplementation by an oxygen supplementation layer formed on a side, distal from the gate 101, of the first insulator layer 106 to the metal oxide semiconductor layer 103.

In some embodiments, the deposition rate of the first insulator layer 106 is correlated with the deposition power and the deposition pressure of the chemical vapor deposition device and the temperature inside the reaction chamber during the preparation of the first insulator layer 106.

In addition, to test densities (i.e., the degree of sparsity) of the first insulator layer 106 formed at different temperatures in the reaction chamber, different first insulator layers 106 are first formed at different temperatures in the reaction chamber, and the wet etch is performed on each of the formed first insulator layers 106 using a 1% HF solution, and the density of the first insulator layer 106 is characterized using a wet etch rate (WER). The larger the wet etch rate of the first insulator layer 106, the looser the first insulator layer 106, and the smaller the wet etch rate of the first insulator layer 106, the denser the first insulator layer 106.

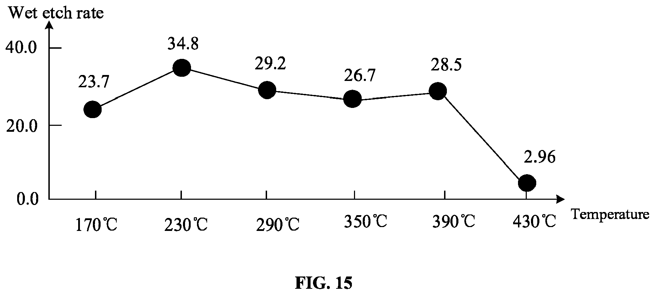

Referring to FIG. 15, the 1% HF solution has a wet etch rate of 34.8 Å/s on the first insulator layer 106 formed when the temperature of the reaction chamber is at 230°C, which is fast relative to the wet etch rate of the first insulator layer 106 formed when the reaction chamber is at other temperatures. That is, the first insulator layer 106 formed when the temperature of the reaction chamber is at 230°C is looser. Therefore, the temperature of the reaction chamber when forming the first insulator layer 106 is made to range from 100°C to 300°C, further range from 200°C to 250°C, for example, 230°C.

In some embodiments, in the case that the thickness of the first insulator layer 106 is small (e.g., less than 500 Å), the metal oxide semiconductor layer 103 is susceptible to being conductive, and the performance of the metal oxide thin-film transistor is poor. In the case that the thickness of the first insulator layer 106 is large (e.g., greater than 2000 Å), cracks are likely to occur in a region where the first insulator layer 106 is overlapped with the source 104 or the drain 105 due to a large internal stress in the film layer of the first insulator layer 106. Because the cracks expose the source 104 or the drain 105, the occurrence of the cracks directly cause the source 104 or the drain 105 to be oxidized or even corroded. Moreover, the hydrogen in a film layer above the source 104 or the drain enters a surface, which is in contact with the source 104 or the drain 105, of the metal oxide semiconductor layer 103 through the source 104 or the drain 105, leading to deterioration of the characteristics of the metal oxide thin film transistor, and in severe cases, leading to sand points defects on the display panel.

Therefore, the thickness of the first insulator layer 106 acquired by the embodiments of the present disclosure ranges from 500 Å to 2000 Å. In one aspect, the metal oxide semiconductor layer 103 is prevented from being susceptible to being conductive, which ensures the performance of the metal oxide thin film transistor; in another aspect, the cracks are prevented from occurring in the first insulator layer 106, which ensures the yield of the metal oxide thin film transistor. Moreover, the thickness of the first insulator layer 106 is small (greater than 500 Å), such that the productivity of the first insulator layer 106 is high, the cost is reduced, and the mass production is improved. Exemplarily, the thickness of the first insulator layer 106 is greater than 500 Å and less than 1100 Å.

In step 308, a supplementation oxygen layer is formed on a side, distal from the base substrate, of the first insulator layer.

In some embodiments, referring to FIG. 2, due to the large mobility of the metal oxide semiconductor layer 103, the number of oxygen vacancies in the metal oxide semiconductor layer 103 is large, such that the characteristics of the metal oxide thin film transistor are more difficult to control. Referring to FIG. 9, after forming the metal oxide semiconductor layer 103, the hydrogen needs to be expelled. For example, an annealing treatment is performed. The annealing treatment simultaneously causes the metal oxide semiconductor layer 103 to lose a portion of oxygen atoms. Accordingly, referring to FIG. 10, to ensure sufficient oxygen concentration in the metal oxide semiconductor layer 103 after the manufacturing of the metal oxide thin film transistor is completed to avoid being conductive, it is necessary to effectively supplement oxygen to the metal oxide semiconductor layer 103 after the first insulator layer 106 is formed. After forming the first insulator layer 106 and before forming the second insulator film 107, the oxygen supplementation layer is formed on the side, distal from the gate 101, of the first insulator layer 106. The oxygen supplementation layer is made of indium gallium zinc oxide, and an orthographic projection of the oxygen supplementation layer on the base substrate 20 is at least partially overlapped with the orthographic projection of the metal oxide semiconductor layer 103 on the base substrate 20.

Because the first insulator layer 106 prepared according to step 307 is looser (i.e., small density), the oxygen in the oxygen supplementation layer diffuses into the metal oxide semiconductor layer 103 through the loose first insulator layer 106. In this way, the number of oxygen vacancies in the metal oxide semiconductor layer 103 is reduced, and the stability of the metal oxide thin-film transistor is improved.

In step 309, the oxygen supplementation layer is removed.

In some embodiments, after the oxygen supplementation of the metal oxide semiconductor layer 103 by the oxygen supplementation layer is completed, the oxygen supplementation layer is removed for subsequent formation of the second insulator film 107.

In step 310, a second insulator film is formed on the side, distal from the base substrate, of the first insulator layer.

In some embodiments, the second insulator film 107 is formed on the side, distal from the gate, of the first insulator layer 106 using a chemical vapor deposition device. The manufacturing conditions of the second insulator film 107 and the first insulator layer 106 are different.

Using a scenario where the second insulator film 107 includes a silicon oxide film layer and a silicon nitride film layer that are successively stacked on the first insulator layer as an example, the silicon oxide film layer of the first insulator layer 106 and the silicon oxide film layer of the second insulator film 107 have differences in film quality. For example, an atomic percentage of oxygen contained in the silicon oxide film layer of the first insulator layer 106 differs significantly from an atomic percentage of oxygen contained in the silicon oxide film layer of the second insulator film 107; a deposition rate in forming the silicon oxide film layer of the first insulator layer 106 differs significantly from a deposition rate in forming the silicon oxide film layer of the second insulator film 107; and a density of the silicon oxide film layer of the first insulator layer 106 differs significantly from a density of the silicon oxide film layer of the second insulator film 107.

The silicon oxide film layer of the second insulator film 107 is employed to improve an interface between the silicon nitride film layer of the second insulator film 107 and the silicon oxide film layer of the first insulator layer 106 and prevents the hydrogen in the silicon nitride film layer from entering the metal oxide semiconductor layer 103 between the source 104 or the drain 105 or from entering an interface, in contact with the metal oxide semiconductor layer 103, of the source 104 or the drain 105. That is, the silicon oxide film layer in the second insulator film 107 mainly functions as a key film layer that improves the interface and prevents the hydrogen from entering the metal oxide thin film transistor. The key film layer is a film layer disposed on a side, proximal to the gate 101, of the second insulator film 107. For example, the key film layer includes the first insulator layer 106, the source 104, the drain 105, and the metal oxide semiconductor layer 103.

The second insulator film 107 expels the hydrogen from the silicon nitride film layer during the high-temperature annealing process and supplements the oxygen from the first insulator layer 106 into the metal oxide semiconductor layer 103.

In summary, some embodiments of the present disclosure provide a method for manufacturing a metal oxide thin film transistor. Due to the high oxygen content of the first insulator layer of the metal oxide thin film transistor prepared by the method, the oxygen in the first insulator layer is capable of diffusing into the metal oxide semiconductor layer, which achieves the oxygen supplementation to the metal oxide semiconductor layer and further improves the stability of the metal oxide thin film transistor. Moreover, the first insulator layer is match with the interface of the metal oxide semiconductor layer, which reduces the surface defects of the metal oxide semiconductor layer. At the same time, the atomic percentage of oxygen in the metal oxide semiconductor layer is greater than 45%, such that there are not too many oxygen vacancies in the metal oxide semiconductor layer, which is not likely to cause a negative bias of characteristics of the metal oxide thin film transistor when the device is operating, and sand point defects of the product caused by the negative bias of the characteristics of the metal oxide thin film transistor are effected reduced.

Some embodiments of the present disclosure also provide a display panel. Referring to FIG. 1, the display panel 01 includes a base substrate 20, and a plurality of metal oxide thin-film transistors 10 as described in the above embodiments (FIG. 1 illustrates one metal oxide thin-film transistor 10) disposed on the base substrate 20. The metal oxide thin film transistor is the metal oxide thin film transistor 10 illustrated in FIG. 1 or FIG. 8.

In some embodiments, the display panel further includes a pixel unit disposed on a side, distal from the base substrate 20, of the second insulator film 107 of the metal oxide thin film transistor 10. The pixel unit at least includes a pixel electrode. The pixel electrode is made of indium tin oxide (ITO).

Some embodiments of the present disclosure also provide a display device. The display device includes a power supply component and a display panel according to the above embodiments. The power supply component is configured to supply power to the display panel.

In some embodiments, the display device is a liquid crystal display device, an organic light-emitting diode (OLED) display device (e.g., an active-matrix organic light-emitting diode (AMOLED)), an electronic paper, a phone, a tablet computer, a television, a display, a laptop computer, a digital photo frame, a navigator, or any other product or component with a display function and a fingerprint identification function.

Described above are merely exemplary embodiments of the present disclosure, and are not intended to limit the present disclosure. Therefore, any modifications, equivalent substitutions, improvements, and the like made within the spirit and principles of the present disclosure shall be included in the protection scope of the present disclosure.

## Claims

1. A metal oxide thin film transistor, comprising:
a gate, a gate insulator layer, a metal oxide semiconductor layer, a source, a drain, and a first insulator layer that are successively stacked on a base substrate; wherein
the first insulator layer is in contact with the metal oxide semiconductor layer;
the first insulator layer is an inorganic insulator layer containing silicon and oxygen, and an atomic percentage of oxygen contained in the first insulator layer is greater than 50%; and
an atomic percentage of oxygen contained in the metal oxide semiconductor layer is greater than 45%.

2. The metal oxide thin film transistor according to claim 1, wherein a thickness of the first insulator layer is less than 2000 Å.

3. The metal oxide thin film transistor according to claim 1 or 2, wherein a peak value of bond energy of a silicon-oxygen bond in the first insulator layer is greater than 1060 cm⁻¹ and does not exceed 1080 cm⁻¹.

4. The metal oxide thin film transistor according to any one of claims 1 to 3, wherein the first insulator layer is a silicon oxide-based film layer formed by controlling an oxygen content during a deposition process, and differences between atomic percentages of oxygen at a plurality of test positions along a thickness direction of the first insulator layer do not exceed 5%.

5. The metal oxide thin film transistor according to any one of claims 1 to 4, wherein
the first insulator layer comprises a first surface and a second surface that are opposite to each other, wherein the first surface is a surface proximal to the metal oxide semiconductor layer, and the second surface is a surface distal from the metal oxide semiconductor layer; and
in a plurality of test positions tested from the second surface to the first surface, the closer the test position is to the second surface, the greater is a difference between atomic percentages of oxygen contained at every adjacent two test positions, and the closer the test position is to the first surface, the smaller is the difference between the atomic percentages of oxygen contained at every adjacent two test positions.

6. The metal oxide thin film transistor according to any one of claims 1 to 5, further comprising: a second insulator film, disposed on a side, distal from the metal oxide semiconductor layer, of the first insulator layer, the second insulator film containing silicon and further containing at least one of oxygen and nitrogen.

7. The metal oxide thin film transistor according to claim 6, wherein
the first insulator layer has an equal density at a plurality of test positions along a thickness direction;
the density of the first insulator layer is less than a density of the second insulator film; and
during etching of the first insulator layer using a hydrogen fluoride solution, an etch rate is greater than 25 Å/s and does not exceed 40 Å/s.

8. The metal oxide thin film transistor according to claim 7, wherein during etching of the first insulator layer using the hydrogen fluoride solution, the etch rate ranges from 28 Å/s to 35 Å/s.

9. The metal oxide thin film transistor according to any one of claims 6 to 8, wherein the second insulator film comprises a silicon nitride film layer.

10. The metal oxide thin film transistor according to any one of claims 6 to 8, wherein the second insulator film comprises a silicon oxide film layer and a silicon nitride film layer that are successively stacked on the first insulator layer; wherein
an atomic percentage of oxygen in the silicon oxide film layer of the second insulator film does not exceed an atomic percentage of oxygen in a silicon oxide film layer of the first insulator layer, and a difference between the atomic percentage of oxygen in the silicon oxide film layer of the second insulator film and the atomic percentage of oxygen in the silicon oxide film layer of the first insulator layer is greater than 5% to 15%.

11. The metal oxide thin film transistor according to any one of claims 6 to 8, wherein the second insulator film comprises a silicon oxide film layer, a silicon oxynitride film layer, and a silicon nitride film layer that are successively stacked on the first insulator layer; wherein
an atomic percentage of oxygen in the silicon oxide film layer of the second insulator film does not exceed an atomic percentage of oxygen in a silicon oxide film layer of the first insulator layer, a difference between the atomic percentage of oxygen in the silicon oxide film layer of the second insulator film and the atomic percentage of oxygen in the silicon oxide film layer of the first insulator layer is greater than 5% to 15%.

12. The metal oxide thin film transistor according to claim 11, wherein an atomic ratio of silicon to oxygen in the silicon oxide film layer is 33:67, an atomic ratio of silicon to oxygen to nitrogen in the silicon oxynitride film layer is 36:52:12, and an atomic ratio of silicon to nitrogen in the silicon nitride film layer is 51:49.

13. The metal oxide thin film transistor according to any one of claims 6 to 12, wherein a ratio of a thickness of the first insulator layer to a thickness of the second insulator film ranges from 0.2 to 0.5.

14. The metal oxide thin film transistor according to any one of claims 1 to 13, wherein an atomic percentage of hydrogen contained in a silicon oxide film layer of the first insulator layer is less than 3%, and a percentage of silicon-hydrogen bonds in the silicon oxide film layer of the first insulator layer is less than 7%.

15. The metal oxide thin film transistor according to any one of claims 1 to 14, wherein a thickness of the source and a thickness of the drain are greater than 3000 Å and less than 6000 Å, the thickness of the first insulator layer is greater than 500 Å and does not exceed 1100 Å, and a slope angle of the source and a slope angle of the drain are both less than 60 degrees.

16. The metal oxide thin film transistor according to any one of claims 1 to 15, wherein
the metal oxide semiconductor layer comprises a first surface and a second surface that are opposite to each other, the first surface being closer to the base substrate; and
a portion, proximal to the first surface, of the metal oxide semiconductor layer contains amorphous or nano-crystalline metal oxide, and a portion, proximal to the second surface, of the metal oxide semiconductor layer contains C-axis crystallized metal oxide; wherein
the amorphous or nano-crystalline metal oxide contains at least one of indium, gallium, zinc, tin, and praseodymium; and
the C-axis crystallized metal oxide containing at least one of indium, gallium, zinc, tin, and praseodymium.

17. The metal oxide thin film transistor according to claim 16, wherein the amorphous or nano-crystalline metal oxide contains indium gallium zinc oxide, an atomic ratio of indium to gallium to zinc in the indium gallium zinc oxide being 4:2:3, 1:1:1, or 1:3:6; and
the C-axis crystallized metal oxide contains indium gallium zinc oxide, an atomic ratio of indium to gallium to zinc in the indium gallium zinc oxide being 4:2:3, 1:1:1, or 1:3:6.

18. The metal oxide thin film transistor according to claim 16 or 17, wherein a carrier mobility of a portion, proximal to the first surface, of the metal oxide semiconductor layer ranges from 10 cm²/V•s to 20 cm²/V•s.

19. A method for manufacturing a metal oxide thin film transistor, comprising:
forming a gate, a gate insulator layer, a metal oxide semiconductor layer, a source, a drain, and a first insulator layer on a base substrate ; wherein
the first insulator layer is in contact with the metal oxide semiconductor;
the first insulator layer is an inorganic insulator layer containing silicon and oxygen, and an atomic percentage of oxygen contained in the first insulator layer is greater than 50%; and
an atomic percentage of oxygen contained in the metal oxide semiconductor layer is greater than 45%.

20. The method according to claim 19, wherein forming the first insulator layer comprises:
introducing nitrous oxide and silicon tetrahydroxide into a reaction chamber, and forming the first insulator layer on the base substrate using a chemical vapor deposition device.

21. The method according to claim 19 or 20, further comprising:
forming an oxygen supplementation layer on a side, distal from the base substrate, of the first insulator layer, wherein the oxygen supplementation layer is made of oxide, an orthographic projection of the oxygen supplementation layer on the base substrate is at least partially overlapped with an orthographic projection of the metal oxide semiconductor layer on the base substrate, and oxygen atoms in the supplementation oxygen layer are capable of diffusing from the first insulator layer into the metal oxide semiconductor layer; and
removing the oxygen supplementation layer.

22. The metal oxide thin film transistor according to any one of claims 19 to 21, wherein a deposition rate of the first insulator layer is greater than 10 Å/s.

23. The metal oxide thin film transistor according to claim 19, wherein a deposition rate of the first insulator layer ranges from 14 Å/s to 16 Å/s.

24. A display panel, comprising: a base substrate, and a plurality of metal oxide thin film transistors as defined in any one of claims 1 to 16 disposed on the base substrate.
